(19) Europäisches Patentamt

European Patent Office

Office européen des brevets

(11) **EP 2 312 644 A1**

(12) **EUROPEAN PATENT APPLICATION**
published in accordance with Art. 153(4) EPC

(43) Date of publication:
**20.04.2011 Bulletin 2011/16**

(21) Application number: **09802990.3**

(22) Date of filing: **29.07.2009**

(51) Int Cl.:
*H01L 31/0264* (2006.01)    *G01J 1/02* (2006.01)

(86) International application number:
**PCT/JP2009/063495**

(87) International publication number:
**WO 2010/013748 (04.02.2010 Gazette 2010/05)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **30.07.2008 JP 2008195618**

(71) Applicants:
• **National University Corporation Nagoya Institute of Technology**
  **Showa-ku**
  **Nagoya-shi**
  **Aichi 466-0061 (JP)**
• **Tokuyama Corporation**
  **Shunan-shi, Yamaguchi-ken 745-8648 (JP)**

(72) Inventors:
• **ONO, Shingo**
  **Nagoya-shi**
  **Aichi 466-0061 (JP)**
• **KAWAGUCHI, Noriaki**
  **Shunan-shi**
  **Yamaguchi 745-8648 (JP)**
• **FUKUDA, Kentaro**
  **Shunan-shi**
  **Yamaguchi 745-8648 (JP)**
• **SUYAMA, Toshihisa**
  **Shunan-shi**
  **Yamaguchi 745-8648 (JP)**

(74) Representative: **Duckworth, Timothy John**
**J.A. Kemp & Co.**
**14 South Square**
**Gray's Inn**
**London WC1R 5JJ (GB)**

(54) **ULTRAVIOLET LIGHT RECEIVING ELEMENT AND METHOD FOR MEASURING AMOUNT OF ULTRAVIOLET LIGHT**

(57)    [Problems to be Solved] To provide a novel ultraviolet light receiving element which is selectively sensitive to ultraviolet radiation, and a method for measuring the dose of ultraviolet radiation using the ultraviolet light receiving element. [Means to Solve the Problems] An ultraviolet detecting layer composed of a thin film of a metal fluoride, such as cerium fluoride, lithium fluoride, magnesium fluoride or calcium fluoride, is formed on a substrate of silica glass, sapphire or the like. Further, at least a pair of an anode and a cathode are formed on the ultraviolet detecting layer to prepare an ultraviolet light receiving element. This ultraviolet light receiving element changes in electric resistivity in accordance with the dose of incident ultraviolet radiation. Thus, the dose of ultraviolet radiation can be measured by taking out and measuring the change as an electric signal.

Fig. 7

Ultraviolet Radiation

## Description

Technical Field:

This invention relates to a novel light receiving element utilizing a thin film of a metal fluoride. More specifically, the present invention provides a light receiving element which is highly sensitive to ultraviolet radiation, but has low sensitivity to visible light, can selectively detect ultraviolet radiation, and can measure the dose of ultraviolet radiation, and a method for measuring the dose of ultraviolet radiation.

Background Art:

In accordance with the miniaturization and large-scale integration of a semiconductor integrated circuit, an ultraviolet light source with a shorter wavelength is demanded as an exposure light source for use in a lithography technology necessary for pattern preparation. Currently, a KrF excimer laser (5.0 eV, wavelength 248 nm) is used, and a lithography technology using an ArF excimer laser (6.4 eV, wavelength 193 nm) is taking off. Moreover, the development of a lithography technology using a $F_2$ laser (7.9 eV, wavelength 157 nm) or extreme ultraviolet radiation (95 eV, wavelength 13 nm) as a next-generation exposure light source has been advanced.

An ultraviolet light receiving element is needed for the detection of ultraviolet radiation generated from any such ultraviolet light source and for the evaluation of its light quantity. As the light receiving element for the ultraviolet range, a silicon (Si)-based light receiving element (photodiode) has generally been used. However, the Si-based light receiving element is also sensitive to visible light, thus posing the problem of requiring a visible light shielding filter. Thus, the development of a new element which can selectively detect light of a shorter wavelength has been expected.

To detect light of a short wavelength selectively, a light receiving element needs to have low sensitivity to light of a long wavelength and high sensitivity to light of a short wavelength. The wavelength selectivity of the light receiving element is determined by the band gap of a material which is used in a detecting layer. This is because the incidence of light having a shorter wavelength than a wavelength corresponding to the band gap of the material for the detecting layer results in the formation of electrons and positive holes, which makes detection possible. Light receiving elements from materials with wide band gaps have so far been developed. Concretely, a light receiving element using diamond [for example, non-patent document 1], and a light receiving element using aluminum gallium nitride (AlGaN) [for example, non-patent document 2] have been developed.

The diamond light receiving element is prepared by forming a highly oriented diamond thin film on a silicon (Si) substrate, a gallium arsenide (GaAs) substrate, or a silicon carbide (SiC) substrate by the plasma chemical vapor deposition method. Such a diamond light receiving element has already been commercially available as an ultraviolet light receiving element having sensitivity to a shorter wavelength than 225 nm. The AlGaN light receiving element is compound crystals of aluminum nitride (AlN) and gallium nitride (GaN). This light receiving element can be expressed by the chemical formula $Al_xGa_{1-x}N$ (x = 0 to 1), and its band gap can be changed depending on its composition. Such an AlGaN thin film is formed on a sapphire substrate or a SiC substrate by an organometallic CVD method. AGaN light receiving element or an AlGaN light receiving element of a low Al content has already been on the market. However, the band gap of diamond is 5.5 eV (wavelength 225 nm), and the band gap of AlGaN is 6.2 to 3.4 eV (wavelength 200 to 365 nm). Thus, these materials are theoretically unable to realize a light receiving element which is selectively sensitive to light of a shorter wavelength than 200 nm.

On the other hand, some metal fluorides have a larger band gap than 6.2 eV. For example, lithium fluoride (LiF) has a band gap of 13.6 eV (wavelength 91 nm), calcium fluoride ($CaF_2$) has a band gap of 10 eV (wavelength 124 nm), strontium fluoride ($SrF_2$) has a band gap of 9. 4 eV (wavelength 132 nm), and barium fluoride ($BaF_2$) has a band gap of 9.1 eV (wavelength 136 nm) [non-patent document 3]. Furthermore, metal fluorides, as a whole, having a relatively large band gap are existent, although their band gaps do not exceed 6.2 eV. For example, the band gap of cerium fluoride ($CeF_3$) is 4.13 eV (wavelength 300 nm).

Many of the metal fluorides can be subjected to the melt growth method such as the Czochralski process, and thus various bulk single crystals are grown. In connection with the bulk single crystals of some metal fluorides, photoconductivity is investigated. Concretely, study has been conducted on the bulk single crystals of magnesium fluoride ($MgF_2$), Yb-doped $CaF_2$, Yb-doped $BaF_2$, Yb-doped $SrF_2$, and Eu-doped $BaF_2$, [non-patent document 4, non-patent document 5]. However, thin films of these metal fluorides have been very difficult to prepare. Thus, ultraviolet light receiving elements utilizing thin films of metal fluorides have been inexistent.

Prior Art Documents:

Non-Patent Documents:

Non-Patent Document 1: K. Hayashi, et al. , "Durable ultraviolet sensors using highly oriented diamond films", Diamond and Related Materials 15, 792-796 (2006)

Non-Patent Document 2: Y. Ohuchi, et al., "Development of Ultraviolet AlGaN Photodiodes (2)", News Report from MITSUBISHI CABLE INDUSTRIES, LTD., No. 100, April 2003.

Non-Patent Document 3: "CRC Handbook of Laser Science and Technology", 30-37.
Non-Patent Document 4: Geoffrey P. Summers, "Photoconductivity in MgF2", J. Phys. C: Solid State Phys., Vol. 8, 3621-3628 (1975)
Non-Patent Document 5: B. Moine, et al., "Photoconductivity and fluorescence properties of divalent ytterbium ions in fluoride crystals", Journal of Luminescence 48 & 49, 501-504 (1991).

Summary of the Invention:

Problems to be solved by the invention:

It is an object of the present invention to provide a novel ultraviolet light receiving element which is selectively sensitive to ultraviolet radiation, and a method for measuring the dose of ultraviolet radiation using the ultraviolet light receiving element.

Means for solving the problems:

In the light of the above-described circumstances, the inventors of the present invention have conducted in-depth studies on methods for preparing thin films of metal fluorides, and the applications of the metal fluoride thin films as ultraviolet light receiving elements. As a result, they have found that the pulsed laser deposition process is preferred as a method for preparing a thin film of a metal fluoride. They have further found that an ultraviolet light receiving element, which is selectively sensitive to ultraviolet radiation with a wavelength of 350 nm or less, is obtained by directly forming an anode and a cathode on a thin film of a metal fluoride prepared by the pulsed laser deposition process. These findings have led them to accomplish the present invention.
According to the present invention, there is provided an ultraviolet light receiving element comprising a substrate, an ultraviolet detecting layer composed of a metal fluoride thin film formed on the substrate, and at least a pair of an anode and a cathode formed on the ultraviolet detecting layer.
In the ultraviolet light receiving element, it is preferred that

(1) the metal fluoride thin film be a thin film of a rare earth metal fluoride, or
(2) the metal fluoride thin film be a thin film of a metal fluoride single crystal.

According to the present invention, there is also provided a method for measuring a dose of ultraviolet radiation, comprising allowing ultraviolet radiation to be incident on an ultraviolet detecting layer composed of a metal fluoride thin film, and taking out, as an electrical signal, an amount of a change in the electric resistivity of the ultraviolet detecting layer, which occurs in accordance with the amount of the incident ultraviolet radiation.

Effects of the invention:

According to the ultraviolet light receiving element of the present invention, the resulting ultraviolet light receiving element has selective sensitivity to ultraviolet radiation. Such an ultraviolet light receiving element can be used preferably in a field, such as lithography, for the detection of ultraviolet radiation generated from an ultraviolet light source and for the evaluation of its light quantity.

Brief Description of the Drawings:

[Fig. 1] Fig. 1 is a schematic view of a pulsed laser deposition apparatus.
[Fig. 2] Fig. 2 is a schematic view of the shape of comb-shaped electrodes.
[Fig. 3] Fig. 3 is a schematic view of a method for connecting an electrometer and an ultraviolet light receiving element.
[Fig. 4] Fig. 4 is a dimensional diagram of a mask for producing the comb-shaped electrodes.
[Fig. 5] Fig. 5 is a view showing the current-voltage characteristics of the ultraviolet light receiving element of a metal fluoride (cerium fluoride) when irradiated with ultraviolet radiation and not irradiated with ultraviolet radiation.
[Fig. 6] Fig. 6 is a view showing the wavelength dependence of the sensitivity of a sample of the metal fluoride ultraviolet light receiving element.
[Fig. 7] Fig. 7 is a schematic view of the metal fluoride ultraviolet light receiving element.
[Fig. 8] Fig. 8 is a view showing the current-voltage characteristics of an ultraviolet light receiving element of a metal fluoride (neodymium fluoride) when irradiated with ultraviolet radiation and not irradiated with ultraviolet radiation.
[Fig. 9] Fig. 9 is a view showing the current-voltage characteristics of an ultraviolet light receiving element of a metal fluoride (ytterbium fluoride) when irradiated with ultraviolet radiation and not irradiated with ultraviolet radiation.

Mode for Carrying Out the Invention:

The ultraviolet light receiving element of the present invention will now be described below. The ultraviolet light receiving element of the present invention is basically composed of a substrate, an ultraviolet detecting layer comprising a metal fluoride thin film formed on the substrate, and at least a pair of an anode and a cathode formed on the ultraviolet detecting layer.
The material for the substrate used in the present invention is not limited, and any inorganic solid materials stable at normal temperatures and normal pressures can be used. Of them, inorganic solid materials which do not deteriorate in a process for forming the metal fluoride thin film are preferred. Concretely, inorganic solid materials, such as vitreous silica, Si, sapphire, GaN, GaAs and SiC, or single crystals of metal fluorides, such as calcium fluoride, magnesium fluoride, cerium fluoride, neodymium fluoride and lanthanum fluoride, are adopted.

The metal fluoride thin film formed on the substrate assumes the form of a single crystal, a polycrystalline form, or an amorphous form. Of these forms, the single crystal is preferred, because it contains few vacancies and has a uniform composition, so that its photosensitivity can easily become uniform. Crystal defects present in the single crystal trap carriers when the light receiving element is operated. As a result, recombination occurs, causing a dark current. Since the crystal defects tend to aggravate characteristics as noted here, the use of the single crystal with few crystal defects is particularly preferred.

In forming the metal fluoride thin film on the substrate, the type of the material for the substrate affects the crystal defect density of the metal fluoride formed. Thus, it is preferred to select a combination of the material for the substrate and the resulting metal fluoride which are minimally different from each other in terms of lattice constant and thermal expansion coefficient. The thickness of the substrate is not limited, but its thickness is preferably about 0.3 to 30 mm.

The method of forming the metal fluoride thin film is not limited, and a publicly known method of crystal growth can be used. Concretely, there can be employed a method such as the pulsed laser deposition method (laser ablation) ; molecular beam epitaxy for growing crystals from a molecular material evaporated in a vacuum; or the LPE method which comprises dissolving a crystal material in a metal liquefied at a high temperature, placing a substrate serving as a seed in the solution, and cooling the solution to grow crystals on the substrate. Of these methods, the pulsed laser deposition method which is a type of vapor deposition is preferred. The pulsed laser deposition method is a physical vapor deposition process which imparts a high energy to a material by irradiation with laser pulses to sublimate the material, thereby depositing it on a substrate. This method enables a thin film having uniform optical properties to be easily prepared, in contrast to chemical vapor deposition by which the optical properties of the resulting thin film are apt to be nonuniform. Thus, the pulsed laser deposition method provides uniform photosensitivity, and proves excellent.

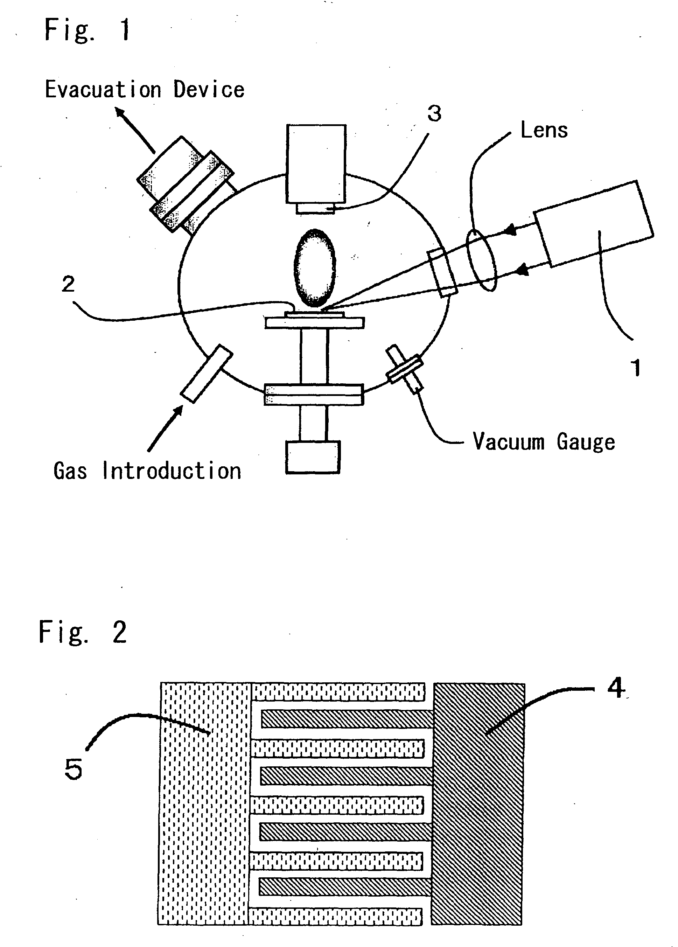

The pulsed laser deposition method, which is a typical vapor deposition process, will be taken as an example for concretely explaining the formation of a metal fluoride thin film on a substrate based on Fig. 1.

The pulsed laser deposition method is one of physical vapor deposition processes using laser light as an energy source for evaporation of a material. This method is also called the laser ablation process. This method is a film formation method which comprises throwing high power pulsed laser light from a laser light source 1, concentrating the laser light on, and directing the laser light at, the surface of a target 2, and utilizing instantaneous peeling of a surface layer portion (ablation) which occurs at this time, thereby depositing atoms, molecules or ions of constituent elements of the target, or their clusters, on a substrate 3. A single crystal, polycrystal, pellets, etc. of the aforementioned metal fluoride can be used as the target. A third harmonic of a Nd:YAG laser or the like is normally used as the laser light.

The ultraviolet light receiving element of the present invention is characterized most by using a thin film of the metal fluoride as an ultraviolet detecting layer.

The type of the metal fluoride is not limited, and metal fluorides which have hitherto been known to the public can be used arbitrarily. Concretely, at least one of the following is used: lithium fluoride, magnesium fluoride, calcium fluoride, scandium fluoride, titanium fluoride, chromium fluoride, manganese fluoride, iron fluoride, cobalt fluoride, nickel fluoride, copper fluoride, zinc fluoride, gallium fluoride, germanium fluoride, aluminum fluoride, strontium fluoride, yttrium fluoride, zirconium fluoride, barium fluoride, lanthanum fluoride, cerium fluoride, praseodymium fluoride, neodymium fluoride, europium fluoride, gadolinium fluoride, terbium fluoride, erbium fluoride, thulium fluoride, ytterbium fluoride, lutetium fluoride, hafnium fluoride, tantalum fluoride, and lead fluoride.

The ultraviolet detecting layer comprising at least one of the metal fluorides having a band gap of 6.2 eV or more, such as lithium fluoride, magnesium fluoride, calcium fluoride, and scandium fluoride among the above ones, can realize a light receiving element selectively sensitive to ultraviolet radiation of a shorter wavelength than 200 nm. Many of the rare earth metal fluorides, in particular, have a band gap in the deep ultraviolet region or the vacuum ultraviolet region, and have moderate conductivity. Thus, they are preferred, because when they are made into an ultraviolet detecting layer, the amount of a change in electric resistivity can be easily taken out as an electric signal.

The metal fluoride thin film using a solid solution of two or more metal fluorides having different band gaps can realize a light receiving element selectively sensitive to light of various wavelengths, by adjusting the mixing ratio of the metal fluorides in the solid solution. Fluorides of rare earth metals, in particular, are preferred, because they are easily solid-soluble with each other, and their solid solution is easy to prepare. The rare earth metal fluorides can form a solid solution in various combinations, but if their ionic radiuses are different too greatly, they may fail to be solid-soluble. Thus, it is preferred to select combinations of the rare earth metal fluorides having ionic radiuses which are close to each other. Concretely, solid solutions such as $Nd_xLa_{1-x}F_3$ (x = 0 to 1), $Ce_xLa_{1-x}F_3$ (x = 0 to 1), and $Pr_xLa_{1-x}F_3$ (x = 0 to 1) are named.

The lower limit of the film thickness of the metal fluoride thin film is not set. However, the film thickness of 50 nm or more on the average is preferred in order to avoid a situation in which the film thickness of the resulting metal fluoride thin film becomes nonuniform and a portion of a considerably small film thickness is formed. In terms of the detection efficiency for ultraviolet radiation, the preferred thickness is equal to or more than the penetration depth of ultraviolet radiation (the length over which the intensity of incident light decays to 1/e) . The penetration depth of ultraviolet radiation varies according to the wavelength of ultraviolet radiation or the type of the metal fluoride used in the ultraviolet detecting layer, but generally, it is about 1 $\mu$m or less. However, this is not limitative, if an increased film thickness impairs the crystallinity of the resulting metal fluoride thin film. The film thickness smaller than the penetration length of ultraviolet radiation may result in a globally satisfactory detection sensitivity. The upper limit of the film thickness is optional unless it impairs crystallinity markedly. From the viewpoint of downsizing and weight reduction, it is preferably 1000 $\mu$ m or less on the average.

The light-receiving area of the resulting metal fluoride thin film is not limited, and may be of such a size that it is not too small to be handled or form an electrode. Such a metal fluoride thin layer formed as a single layer on the substrate can act as an ultraviolet detecting layer, but does not necessarily require to be a single layer, but may be a multilayer film. For example, the formation of a certain buffer layer, which eliminates a lattice mismatch, between the substrate and the metal fluoride thin film can improve the crystallinity of the metal fluoride thin film. Also, an antioxidant film may be formed on the outermost layer of the ultraviolet light receiving element.

A metal film or a conductive metal oxide film can be used for an electrode to be formed on the metal fluoride thin film. The film thickness of this film is not limited, but 1 nm or more is preferred for obtaining minimum required durability. From the viewpoint of downsizing and weight reduction, 1000 $\mu$m or less is preferred. A plurality of metals or metal oxides may be used to form a multilayer film. As the material for the electrode, a publicly known metal or conductive oxide can be used arbitrarily. Concretely, at least one of aluminum, titanium, nickel, cobalt, gold, silver, copper, chromium and ITO (indium tin oxide) is used.

A publicly known metal film formation technology can be used arbitrarily as a method of forming the metal film. Preferably, vacuum evaporation or deposition is adopted. The vacuum evaporation process is a method which involves sublimating or evaporating an evaporation material by heating in a vacuum to deposit the resulting particles on a substrate, thereby forming a uniform film-shaped sample. By using a shield called a mask, a portion not to be deposited on is blocked, whereby an electrode of an optional shape can be formed.

There are no limitations on the shape of the electrode. However, electrodes composed of a pair of electrodes 4 and 5 (as shown in Fig. 2) engaging each other in the shape of a comb (comb-shaped electrodes) are conceivable. Such electrodes are preferred, because they can have a light-receiving area increased in comparison with the formation of a pair of rectangular electrodes, and thus show higher sensitivity. The electrode-to-electrode distance is preferably short, because the short distance can increase the response speed. One of the pair of electrodes is an anode, and the other electrode is a cathode.

To measure the dose of ultraviolet radiation, a photoconductive effect is utilized. Upon the incidence of ultraviolet radiation on the metal fluoride, electrons present in the valence band are excited by incident light and raised to the conduction band. As a result, electrons and positive hole carriers are generated in the portion which has been electrically neutral. These carriers are driven by an electric field from the outside, and contribute to current conduction, thereby decreasing resistance. Afterwards, the electrons present in the conduction band, and the positive holes present in the valence band recombine, putting an end to contribution to conduction. With this effect being utilized, the photoconductive substance is converted into a form in which an electric field can be applied from the outside, and the amount of a change in electric conductivity is detected as an electric signal.

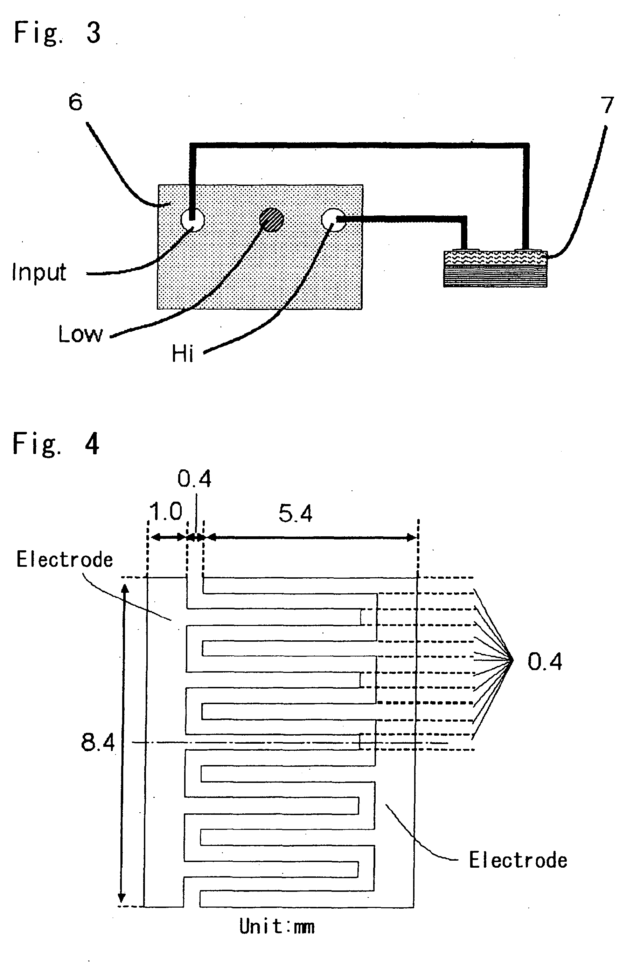

The method of measuring the dose of ultraviolet radiation will be described concretely. As shown in Fig. 3, an electrometer 6 and an ultraviolet light receiving element 7 are connected in series. In the present invention, the electrometer refers to a device which can measure current and electric resistance while applying voltage, and a publicly known device can be used arbitrarily. The range of an appropriate voltage applied during measurement of resistivity varies according to the conductivity of the metal fluoride thin film, contact resistance between the anode/cathode and the metal fluoride thin film, or the area of the anode or cathode. Thus, it is preferred that optimum values be determined beforehand by experiments. When the ultraviolet detecting layer is irradiated with ultraviolet radiation, resistivity lowers during irradiation because of the photoconductive effect. Advisably, changes in resistivity according to changes in the dose of ultraviolet radiation are examined beforehand to draw a calibration curve, which enables the dose of ultraviolet radiation to be measured. The method of the present invention is designed to measure the dose of ultraviolet radiation, but can be applied merely as a method of detecting the presence or absence of ultraviolet radiation.

Examples:

The preset invention will be concretely described by reference to its examples, but the present invention is in no way restricted by these examples. Not all of combinations of the features explained in the examples are essential to the means for solution in the present invention.

Example 1

A thin film of cerium fluoride (CeF$_3$) was prepared on a vitreous silica substrate by use of a pulsed laser deposition apparatus. Vitreous silica measuring 20×20×0.5 (width × length×thickness, unit: mm) was used as the substrate. A sintered body of CeF$_3$ was used as a target. Using a rotary pump and an oil diffusion pump, the interior of a chamber was evacuated to a vacuum of about $2.0×10^{-4}$ Pa. Then, the substrate and the target were shielded from each other by a metal plate so that no film formation took place. In this state, the target was irradiated with pulsed laser with a wavelength of 355 nm and a cycle frequency of 10 Hz to strip and remove for 10 minutes an outermost layer of the target having a possibility for adhesion of impurities. Then, the metal plate between the substrate and the target was detached to begin film formation or deposition. Film formation was performed under the following conditions: The distance between the target and the substrate was 4.2 cm, the deposition time was 240 minutes, the substrate temperature was 400°C, and the amount of energy of laser irradiation per unit area was 15.5 (J/cm$^2$). The amount of energy of laser irradiation per unit area was calculated as $E/\pi D^2/4$ where D was the width of a laser irradiation crater of the target after laser irradiation, and E was the pulse energy during the experiments. The pulse energy was calculated based on the average laser power P during the experiments from the following equation:

$$E \ (J) \ = \ P \ (W)/10 \ (Hz)$$

The film thickness of a metal fluoride thin film prepared under the above conditions for film formation was evaluated by the observation of a sectional SEM image, and found to be 205 nm.

Then, electrodes of the dimensions shown in Fig. 4 were formed on the metal fluoride thin film by the vacuum evaporation process using a mask to obtain a metal fluoride ultraviolet light receiving element according to the present invention. A stainless (SUS304) mask of 0.2 mm in thickness was used as the mask. A helical coil of a tungsten wire was used as a heater, and aluminum was used for a vacuum evaporation source. Evacuation was carried out until $4×10^{-4}$ torr or lower by means of a rotary pump and an oil diffusion pump.

The so prepared ultraviolet light receiving element was connected to the electrometer 6 as shown in Fig. 3. Keithley Electrometer Model 6517 was used as the electrometer. Voltages of 200, 400, 600, 800 and 1000 (V) were applied from a power source incorporated in the electrometer to the ultraviolet light receiving element, and the value of electric resistance between the electrodes was measured to determine the electric resistivity of the ultraviolet light receiving element. Using the applied voltage and the value of electric resistance, current was calculated from Ohm's law, and voltage-current characteristics were investigated. These experiments were conducted in the following manner: The value of electric resistance at room temperature (23°C) in a dark room was recorded at each of the applied voltages, and then the value of electric resistance was recorded when ultraviolet irradiation (irradiation from 14 cm vertically upward of the ultraviolet light receiving element) was performed by an ultraviolet light source (HLR100T-2 produced by Sen Lights Corporation).

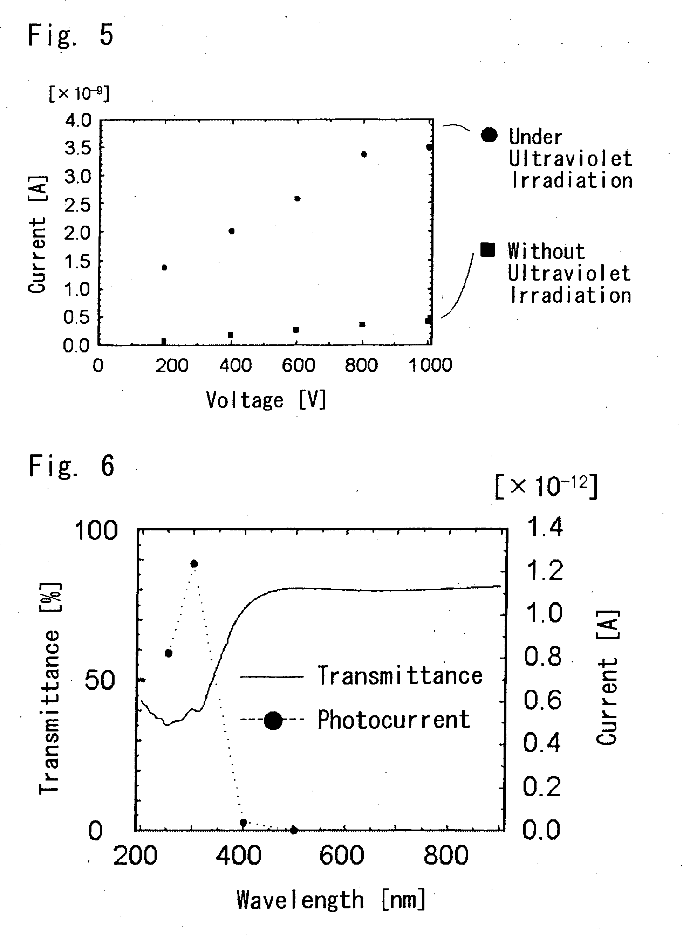

A plot of the current-voltage characteristics is shown in Fig. 5. The electric resistivity upon application of a voltage of 600 V was $5.00×10^{15}$ ($\Omega \cdot$ m) in the absence of ultraviolet irradiation, and $5.75×10^{14}$ ($\Omega \cdot$ m) in the presence of ultraviolet irradiation. From these results, a decrease in the resistivity under ultraviolet irradiation was observed, and the actions of the ultraviolet light receiving element were demonstrated. Further, the wavelength dependence of ultraviolet sensitivity was investigated using the spectrofluorometer SPEX Fluorolog 2 (lamp: OSRAM's Xe lamp 450 W, spectroscope: a product of SPEX, U.S.A., SPEX 1680 0.22 m Double spectrometer MODEL 1680B S/N 1990). Fig. 6 shows the wavelength dependence of spectral transmittance and photocurrent. When the wavelength of incident ultraviolet radiation was 300 nm, sensitivity was shown. At 400 nm or longer, little sensitivity was shown. From these findings, the wavelength selectivity of the metal fluoride thin film light receiving element was confirmed.

Example 2

A thin film of NdF$_3$ was prepared on a vitreous silica substrate in the same manner as in Example 1, except that a sintered body of NdF$_3$ was used as the target instead of the sintered body of CeF$_3$. The film thickness of the resulting metal fluoride thin film was evaluated by the observation of a sectional SEM image, and found to be 200 nm. Then, an ultraviolet light receiving element was obtained by the same method as in Example 1. The so prepared ultraviolet light receiving element was connected to the electrometer 6 as shown in Fig. 3. A digital ultrahigh resistance/microammeter 8340A produced by ADC Corporation was used as the electrometer. A voltage of up to 300 (V) was applied from the power source incorporated in the electrometer to the ultraviolet light receiving element, and the value of electric resistance between the electrodes was measured to determine the electric resistivity of the ultraviolet light receiving element. Using the applied voltage and the value of electric resistance, current was calculated from Ohm's law, and voltage-current characteristics were investigated. The experiments were conducted in the following manner: The value of electric resistance at room temperature (23°C) in a dark room was recorded at each voltage applied, and then the value of electric resistance was recorded when ultraviolet irradiation (irradiation from 12 cm vertically upward of the ultraviolet light receiving element) was performed by an ultraviolet light source (HLR100T-2 produced by Sen Lights Corporation).

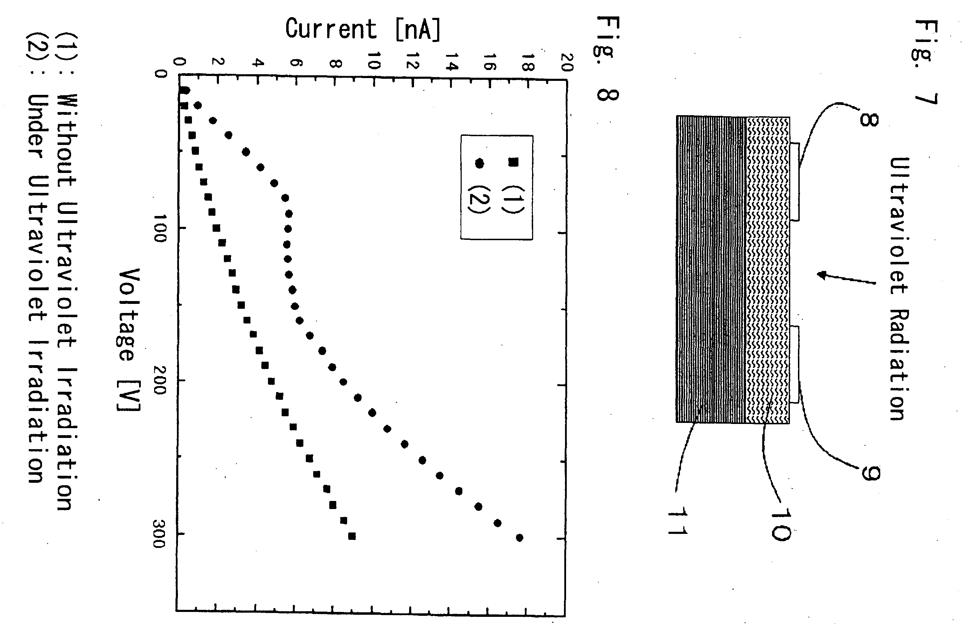

A plot of the current-voltage characteristics is shown in Fig. 8. The electric resistivity upon application of a voltage of 300 V was $8.25 \times 10^{13}$ ($\Omega \cdot$ m) in the absence of ultraviolet irradiation, and $4.23 \times 10^{13}$ ($\Omega \cdot$ m) in the presence of ultraviolet irradiation. From these results, a decrease in the resistivity under ultraviolet irradiation was observed, and the actions of the ultraviolet light receiving element were demonstrated. When the ultraviolet light receiving element was irradiated with a He-Ne laser having a wavelength of 633 nm and an output of 15 mW, no change in the electric resistivity was observed.

Example 3

A thin film of $YbF_3$ was prepared on a vitreous silica substrate in the same manner as in Example 1, except that a sintered body of $YbF_3$ was used as the target instead of the sintered body of $CeF_3$. The film thickness of the resulting metal fluoride thin film was evaluated by the observation of a sectional SEM image, and found to be 600 nm. Then, an ultraviolet light receiving element was obtained by the same method as in Example 1. The electric resistivity and voltage-current characteristics of the so prepared ultraviolet light receiving element were investigated by the same methods as in Example 2.

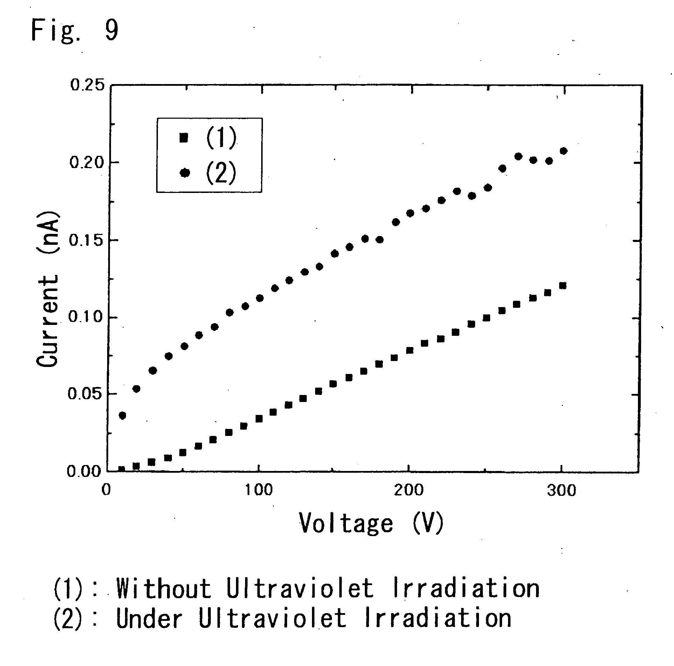

A plot of the current-voltage characteristics is shown in Fig. 9. The electric resistivity upon application of a voltage of 300 V was $6.20 \times 10^{15}$ ($\Omega \cdot$ m) in the absence of ultraviolet irradiation, and $3.63 \times 10^{15}$ ($\Omega \cdot$ m) in the presence of ultraviolet irradiation. From these results, a decrease in the resistivity under ultraviolet irradiation was observed, and the actions of the ultraviolet light receiving element were demonstrated. When the ultraviolet light receiving element was irradiated with a He-Ne laser having a wavelength of 633 nm and an output of 15 mW, no change in the electric resistivity was observed.

Description of the Numerals:

1    Laser light source

2    Target

3    Substrate

4    Electrode

5    Electrode

6    Electrometer

7    Ultraviolet light receiving element

8    Electrode

9    Electrode

10    Ultraviolet detecting layer

11    Substrate

**Claims**

1. An ultraviolet light receiving element, comprising:

   a substrate;
   an ultraviolet detecting layer composed of a metal fluoride thin film formed on the substrate; and
   at least a pair of an anode and a cathode formed on the ultraviolet detecting layer.

2. The ultraviolet light receiving element according to claim 1, wherein the metal fluoride thin film is a thin film of a rare earth metal fluoride.

3. The ultraviolet light receiving element according to claim 1, wherein the metal fluoride thin film is a thin film of a metal fluoride single crystal.

4. A method for measuring a dose of ultraviolet radiation, comprising:

   allowing ultraviolet radiation to be incident on an ultraviolet detecting layer composed of a metal fluoride thin film; and
   taking out, as an electrical signal, an amount of a change in electric resistivity of the ultraviolet detecting layer, which occurs owing to an amount of the incident ultraviolet radiation.

Fig. 1

Fig. 2

## Fig. 3

## Fig. 4

Unit:mm

Fig. 5

Fig. 6

Fig. 7

Ultraviolet Radiation

8    9    10    11

Fig. 8

(1): Without Ultraviolet Irradiation
(2): Under Ultraviolet Irradiation

Fig. 9

(1) : Without Ultraviolet Irradiation
(2) : Under Ultraviolet Irradiation

## INTERNATIONAL SEARCH REPORT

| International application No. |
| --- |
| PCT/JP2009/063495 |

A. CLASSIFICATION OF SUBJECT MATTER
H01L31/0264(2006.01)i, G01J1/02(2006.01)i

According to International Patent Classification (IPC) or to both national classification and IPC

B. FIELDS SEARCHED

Minimum documentation searched (classification system followed by classification symbols)
H01L31/0264, G01J1/02

Documentation searched other than minimum documentation to the extent that such documents are included in the fields searched
Jitsuyo Shinan Koho          1922–1996   Jitsuyo Shinan Toroku Koho   1996–2009
Kokai Jitsuyo Shinan Koho   1971–2009   Toroku Jitsuyo Shinan Koho   1994–2009

Electronic data base consulted during the international search (name of data base and, where practicable, search terms used)
JSTPlus/JMEDPlus/JST7580(JDreamII)

C. DOCUMENTS CONSIDERED TO BE RELEVANT

| Category* | Citation of document, with indication, where appropriate, of the relevant passages | Relevant to claim No. |
| --- | --- | --- |
| A | JP 2007-45870 A  (Stella Chemifa Corp.), 22 February 2007 (22.02.2007), entire text; all drawings (Family: none) | 1-4 |

☐  Further documents are listed in the continuation of Box C.   ☐   See patent family annex.

| | |
| --- | --- |
| *    Special categories of cited documents:<br>"A"   document defining the general state of the art which is not considered    to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |
| Date of the actual completion of the international search<br>     15 October, 2009 (15.10.09) | Date of mailing of the international search report<br>     27 October, 2009 (27.10.09) |
| Name and mailing address of the ISA/<br>     Japanese Patent Office | Authorized officer |
| Facsimile No. | Telephone No. |

Form PCT/ISA/210 (second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **K. Hayashi et al.** Durable ultraviolet sensors using highly oriented diamond films. *Diamond and Related Materials,* 2006, vol. 15, 792-796
- **Y. Ohuchi et al.** Development of Ultraviolet AlGaN Photodiodes (2). MITSUBISHI CABLE INDUSTRIES, LTD, April 2003
- CRC Handbook of Laser Science and Technology. 30-37
- **Geoffrey P. Summers.** Photoconductivity in MgF. *J. Phys. C: Solid State Phys.,* 1975, vol. 8, 3621-3628
- **B. Moine et al.** Photoconductivity and fluorescence properties of divalent ytterbium ions in fluoride crystals. *Journal of Luminescence,* 1991, vol. 48, 49, 501-504